# EUROPEAN PATENT APPLICATION

(11) **EP 1 405 935 A2**
(43) Date of publication of application: **07.04.2004**
(21) Application number: 03255884.3
(22) Date of filing: 19.09.2003
(51) Int. Cl.: C25F 5/00, G01N 27/26

(54) **Control loop for use in electrochemical stripping**

(30) Priority: 27.09.2002 US 260055
(71) Applicant: UNITED TECHNOLOGIES CORPORATION, Hartford, CT 06101 (US)
(72) Inventor: Riewe, Curtis Heath, Manchester, CT 06040 (US)
(74) Representative: Leckey, David H.

(57) **Abstract**

The present invention relates to a control loop (1) to be used in a system for stripping a coating from a part (2). The control loop comprises an electrometer (3) for measuring a potential between the part (2) and a reference electrode (6) and generating a voltage output signal, an operational amplifier (4) for comparing the voltage output signal to a set point voltage and for producing an output signal to be used to reduce the difference between the voltage output signal and the set point voltage, and a high current power transistor (5) for supplying a current to the part (2).

## Description

### BACKGROUND OF THE INVENTION

The present invention relates to a control circuit or loop for use in a system for electrochemically removing a coating from a part and to a system wherein multiple parts may be processed at a time with each part having a separate control loop.

Various systems for removing coatings from parts have been developed and used in recent years. In one such system, a process controller was used to control the potential of multiple parts. A practical consequence of this control architecture was that many of the parts in the load being stripped were not actually at the optimum potential for stripping during most of the run. At the beginning of the stripping process, only a few parts in the load were held at the correct potential, with the remaining parts being at potentials above or below a set point potential. In either case, the stripping process was not effective in removing coatings from the substrates. Coatings were not stripped quickly and damage was done to the substrate material of the part. To summarize, multiple parts per control loop result in damage to hardware and unacceptably long stripping times.

### SUMMARY OF THE INVENTION

Accordingly, it is an object of the present invention to provide a control loop for use in a system for stripping a coating from a part.

It is a further object of the present invention to provide a control loop as above which provides an optimized potential to the part to be stripped.

The foregoing objects are attained by the control loop of the present invention.

In accordance with the present invention, a control loop to be used in a system for stripping a coating from a part, such as a turbine blade is provided. The control loop broadly comprises means for measuring a potential between the part and a reference electrode and generating a voltage output signal, means for comparing the voltage output signal to a set point voltage and for producing an output signal to be used to reduce the difference between the voltage output signal and the set point voltage, and means for supplying current to the part.

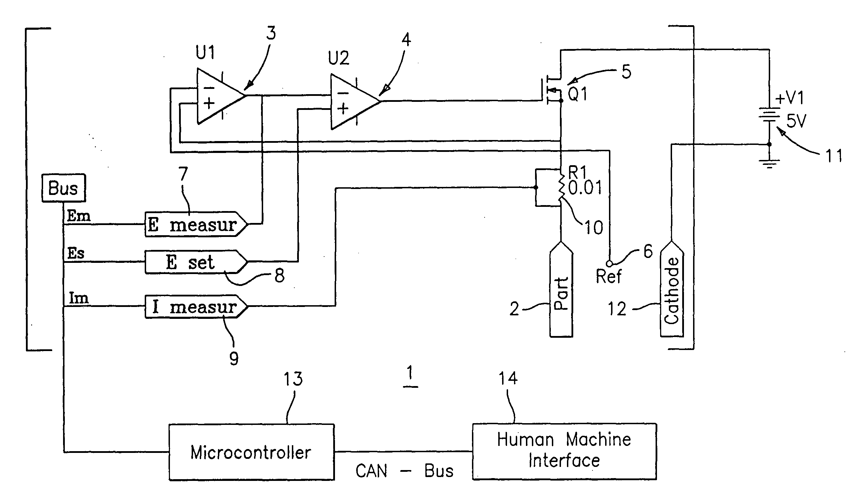

Other details of electrochemical stripping using single loop control system of the present invention, as well as other objects and advantages attendant thereto, are set forth in the following detailed description and the accompanying drawing wherein like reference numerals depict like elements.

### BRIEF DESCRIPTION OF THE DRAWINGS

The Figure is a schematic representation of a control loop to be used in a coating stripping system in accordance with the present invention.

### DETAILED DESCRIPTION OF THE PREFERRED EMBODIMENT(S)

Referring now to the Figure, a control loop 1 to be used in a system for stripping a coating from a part 2, such as a jet engine component, is illustrated. The control loop 1 is capable of electrochemically stripping a coating from a component in a stripping solution, such as a 5% hydrochloric acid stripping solution. The control loop 1 may be integrated into a fixture which minimizes external wiring.

In one embodiment of the present invention, the major components of the control loop 1 include an electrometer 3, an operational amplifier 4, a high current MOSFET transistor 5, an analog to digital converter 7, a digital to analog converter 8, a high resolution analog to digital converter 9, a current measurement resistor 10, a high current power supply 11 and a cathode 12. The electrometer 3 measures the potential between the part 2, which is connected as the anode, and a reference electrode 6 and outputs a voltage output signal with respect to ground. The reference electrode 6 may be an Ag/AgCl electrode or a hydrogen electrode. A suitable electrometer that may be used is a Burr Brown's INA 116 Ultra Low Input Bias Current Instrument Amplifier. An electrometer grade instrument amplifier is necessary to prevent the reference electrode 6 from becoming polarized.

The operational amplifier 4 compares the voltage output signal to a set point voltage signal and provides an output signal controlling the high current transistor 5 that will reduce the difference between the electrometer output and the set point. A Burr Brown's OPA 234 low power precision single-supply operational amplifier may be used for the operational amplifier.

The high current MOSFET transistor 5 supplies the current to the part 2. The high current MOSFET transistor 5 may be formed from an Ixis IXFN 200N07 HiPerFET™ Power MOSFET or similar device.

The control loop 1 also has a digital to analog converter 8 which provides a set point voltage to the operational amplifier 4. The digital to analog converter 8 receives a command from a microcontroller 13 to set the correct potential. The control loop 1 also has an analog to digital converter 7 that measures the voltage output from the electrometer 3. The digitized value is reported to the microcontroller 13 upon request from the microcontroller 13. The control loop 1 also has a current measuring resistor 10 having a value of approximately 0.01 ohm. The voltage drop across the current measuring resistor 10 is measured by a high precision analog to digital converter 9. The measurement of said converter is reported to the microcontroller 13 on request.

In addition to the circuit or control loop 10 described above, a HP 6680A power supply 11 may be used to provide a voltage in the range of +5v DC at a current greater than 10 amps. The solution potential near part 2 and the current are measured and reported through the microcontroller 13 to a human machine interface 14 such as a computer or a programmed process controller. The set point is obtained from the human machine interface 14 and inputted into the microcontroller. The microcontroller communicates to the human machine interface on a communication bus such as CAN controller area network.

To remove a coating from a component such as a turbine blade, the component is first grit blasted. The blade is then inspected for corrosion or pitting. The reference electrode 6 then may be checked against an unused reference electrode. The operating set point is then set to a desired potential which depends on the type of blade being stripped. For example, for one particular type of blade, the set point may be 130 mv. The turbine blade is then electrically connected and immersed into a stripping solution, such as 5% hydrochloric acid stripping solution. Current is then applied to the blade for a desired time which again depends on the particular type of blade being cleaned. For example, for a particular type of blade, the time may be until five minutes after the second major inflection point in the current vs time curve has been reached and then stopped. Again depending on the blade being stripped, the current may be less than 0.150 amps. The blade is then disconnected and rinsed in water. Following rinsing, the blade may be blown dry with filtered air which is oil free. Thereafter, the blade may be tinted and heated at 1050-1300 degrees Fahrenheit (565°C-704°C) in air for 45 minutes and inspected.

The control loop 10 of the present invention provides an optimum potential to the part to be stripped. Thus, the part may be stripped quickly without damaging the part's substrate. If multiple parts are to be stripped, each part may be provided with its own control loop 1.

It is apparent that there has been provided in accordance with the present invention an electrochemical stripping system using single loop control which fully satisfies the objects, means, and advantages set forth hereinbefore. While the present invention has been described in the context of specific embodiments thereof, other alternatives, modifications, and variations will become apparent to those skilled in the art having read the foregoing description. Accordingly, it is intended to embrace those alternatives, modifications, and variations as fall within the broad scope of the appended claims.

## Claims

1. A control loop (1) to be used in a system for stripping a coating from a part (2), said control loop comprising:
means (3) for measuring a potential between the part (2) and a reference electrode (6) and generating a voltage output signal;
means (4) for comparing said voltage output signal to a set point voltage and for producing an output signal to be used to reduce the difference between the voltage output signal and the set point voltage; and
means (5) for supplying current to said part.

2. A control loop according to claim 1, further comprising means (8) for providing a set point voltage to said comparing means (4).

3. A control loop according to claim 2, wherein said set point voltage providing means comprises a digital to analog converter (8).

4. A control loop according to claim 2 or 3, further comprising a microcontroller (13) for forwarding a command to said set point voltage providing means (8) to set a potential.

5. A control loop according to any preceding claim, wherein said measuring means comprises an electrometer (3).

6. A control loop according to claim 5, further comprising means (7) for measuring the voltage output from said electrometer (3) and reporting the voltage output to a or the microcontroller (13).

7. A control loop according to any preceding claim, wherein said reference electrode comprises a Ag/AgCl reference electrode (6).

8. A control loop according to any of claims 1 to 6, wherein said reference electrode comprises a hydrogen electrode (6).

9. A control loop according to any preceding claim, wherein said comparing means comprises an operational amplifier (4).

10. A control loop according to any preceding claim, wherein said current supplying means comprises a high current power transistor (5).

11. A control loop according to any preceding claim, further comprising a power supply (1) for providing a voltage in the range of +5v DC at greater than 10 amps.

12. A control loop according to any preceding claim, further comprising a current measuring resistor (10), means (9) for measuring the voltage drop across the current measuring resistor (10), and a or said microcontroller (13) for receiving a signal representative of the measured voltage drop.

13. A control loop according to any preceding claim, further comprising a or said microcontroller (13) and an interface (14) for inputting a set point to the microcontroller (13).
